# EUROPEAN PATENT SPECIFICATION

(11) **EP 0 405 301 B1**
(45) Date of publication and mention of the grant of the patent: **30.08.1995**
(21) Application number: 90111561.8
(22) Date of filing: 19.06.1990
(51) Int. Cl.: H01L 21/68

(54) **Apparatus for handling semiconductor wafers**
Vorrichtung zur Handhabung von Halbleiterplättchen
Dispositif de manipulation de plaquettes semi-conductrices

(30) Priority: 29.06.1989 US 373734
(43) Date of publication of application: 02.01.1991
(73) Proprietor: APPLIED MATERIALS, INC., Santa Clara, California 95052-8039 (US)
(72) Inventor: Murdoch, Steven, Palo Alto, California 94306 (US)
(74) Representative: Kahler, Kurt, Dipl.-Ing.

(56) References cited:
- EP-A- 0 290 218
- EP-A- 0 402 900
- US-A- 4 453 757
- PATENT ABSTRACTS OF JAPAN vol. 12, no. 7 (E-571)(2854), 9 January 1988 ; & JP-A-62 165 946
- PATENT ABSTRACTS OF JAPAN vol. 11, no. 309 (E-547)(2756), 8 October 1987 ; & JP-A-62 101 045

## Description

This invention relates to an apparatus for handling semiconductor wafers used in the production of integrated circuit structures. More particularly, this invention relates to an apparatus for handling semiconductor wafers in a manner which will permit transporting of the wafer from one processing station to another without handling of the wafer, thus reducing formation of loose particulate, and which also permits processing of both the top and bottom surfaces of the wafer equally while mitigating the effects of shadowing.

During the processing of semiconductor wafers such as silicon wafers to form integrated circuit structures in and on the wafer, it is necessary to perform a number of processing steps which require transport of the wafer to various apparatuses or chambers within an apparatus. Conventionally this involves the direct physical engagement of the wafer, either manually or by robotic means, to move the wafer between such apparatuses or process stations.

Each such step of physical handling of the wafer can result in the dislodgment of particulates from the wafer surfaces during such handling or other damage to the wafer which can lead to in failure of some of the chips or dies, thus lowering the yield of chips per wafer.

Integrated circuit structures are usually formed on or in one surface of a semiconductor wafer. As a result, wafer handling and transfer methodologies have been developed for processes which involve only one surface of a wafer, conventionally the upper surface.

However, there is a growing amount of interest in processing both surfaces of a semiconductor wafer during the construction of integrated circuit structures, and in particular, the necessity to remove oxide films from the backside of wafers without surface contact either front or back. To remove these oxide films that have been deposited, the wafer face (the front surface) is conventionally pushed upward to some grounding surface, thereby endangering the already processed surface with a contacting and rubbing motion creating particulate.

Since the wafer is conventionally supported during processing by resting the bottom surface of the wafer on a support surface, processing of the bottom surface by conventional means can require turning the wafer over to expose the bottom surface. This not only involves extra process steps, but even further direct handling of the wafer as well, which can further add to the risk of damage to the wafer, e.g., from particulates which may become dislodged from the wafer surfaces during such handling.

Furthermore, while supporting the wafer from the sides during processing rather than the bottom would allow access to the bottom surface of the wafer for processing, it is well known that the placement of any device or material near the wafer during processing can cause severe "shadowing" of the process on the wafer, i. e. the placement of a device or material adjacent the wafer during processing results in incomplete etching, deposition, etc. in those areas of the wafer surface immediately adjacent such device or material.

US-A-4,473,455 describes a wafer holding assembly wherein a number of wafers are loaded onto a plate. Pedestal elements engage the backside surfaces of the wafers. The wafers are held in the plate by clips which are attached to springs mounted on the plate and which engage the ends edges and the edge of the front surfaces of the wafers.

US-A-4,306,731 and US-A-4,779,877 disclose a wafer support assembly comprising a wafer plate assembly having an aperture larger than the diameter of the wafer. Spring clips comprising spring bands or spring wires carried by the wafer plate assembly have arcuate ends which engage the wafer surfaces adjacent the edges of the wafer.

Patent Abstracts of Japan, vol. 12, no. 7, and JP-A-62-165946 discloses a wafer clamping assembly consisting of a leaf spring and retaining ring that secure a wafer to a base assembly. When the retaining ring is depressed, the leaf spring is pulled outwardly, allowing the wafer to be inserted into the retaining ring. When the retaining ring is released, the leaf spring moves inwardly, thereby grasping and securing the wafer to the base assembly.

EP-A-0 409 900, which is an earlier European application in the sense of Article 54(3) EPC, discloses a wafer retaining ring that includes a plurality of circumferentially spaced biasing members. The biasing members retain a wafer within the retaining ring and thereby allow wafer processing to proceed with an only minimum amount of wafer shadowing being attributable to the presence of the retaining ring.

It is the object of the invention to provide an apparatus which would permit easy and safe transport of a wafer from one process station to another without manual handling of the wafer as well as equal processing of both sides of a semiconductor wafer without increasing the risk of shadowing of the wafer on either side of the surface of the wafer during processing.

This object is solved by the apparatus of claim 1. Advantageous features are characterized in the dependent claims.

The apparatus of the invention permits transporting of the wafer without direct handling to reduce dislodgement of particulate from the wafer during such handling as well as other damage to the wafer from such direct handling.

Specifically, a wafer retaining means is used which support the wafer during processing in a manner which mitigates the effects of shadowing by objects adjacent the wafer during processing. Also, this wafer retaining means permits equal processing of both the top and bottom surfaces of the wafer.

Further features and advantages of the invention will be apparent from the following description and accompanying illustrations.

Figure 1 is a vertical cross-sectional view of a retaining ring holding a semiconductor wafer.

Figure 2 is a top view showing a semiconductor wafer being transported by robotic means to a retaining ring storage station having one or more wafer retaining rings stacked therein.

Figure 3 is a top view showing a semiconductor wafer supported by robotic means positioned over the storage station containing one or more wafer retaining rings.

Figure 4 is a die section view showing a semiconductor wafer supported by robotic means positioned over the storage station containing one or more wafer retaining rings as in Figure 3 and also showing the position of a rotatable orientation or flat finding platform onto which the wafer will be unloaded by the robotic means to permit the wafer to be rotated to orient the flat edge of the wafer with respect to the retaining ring.

Figure 5 is a top view showing the semiconductor wafer loaded on the orientation platform with the robotic means being withdrawn.

Figure 6 is a side section view of the structure shown in Figure 5.

Figure 7 is a side section view showing the orientation platform lowering the semiconductor wafer into engagement with the top retaining ring contained in the retaining ring storage station.

Figures 8-10 are fragmentary top views showing, sequentially, the engagement of the semiconductor wafer by metallic spring clips carried by the retaining ring.

Figure 11 is a fragmentary side section view of end of the tip of the clip which engages the wafer edge.

Figure 12 is a fragmentary cut-away top view of the end of the tip of the clip which engages the wafer edge.

Figure 13 is a side section view showing the top retaining ring in the retaining ring storage station having a semiconductor wafer loaded therein and the entire storage station being indexed upwardly to the plane of the robotic means and the robotic means being extended to engage the top retaining ring and remove it from the storage station.

Figure 14 is a top view showing the robotic means laterally moving the retaining ring containing the semiconductor wafer away from the retaining ring storage means in preparation for moving the retaining ring and semiconductor wafer therein to a processing station.

Figure 15 is a top view of an alternate embodiment of the wafer-engaging clip showing a ceramic end piece bonded to the metal clip.

Figure 16 is a top view of another alternate embodiment of the wafer-engaging clip showing an additional spring arm integral with the clip to eliminate the need for a separate spring to urge the clip into yieldable engagement with the end edge of the wafer.

Figure 17 is a side view of the retaining ring showing grooves formed in the side thereof which may be engaged by the robotic means to transport the retaining ring and wafer loaded therein from one process station or apparatus to another without direct contact with the wafer.

Figure 18 is a fragmentary side section view of the wafer/retaining ring assembly of the invention being held in a processing station.

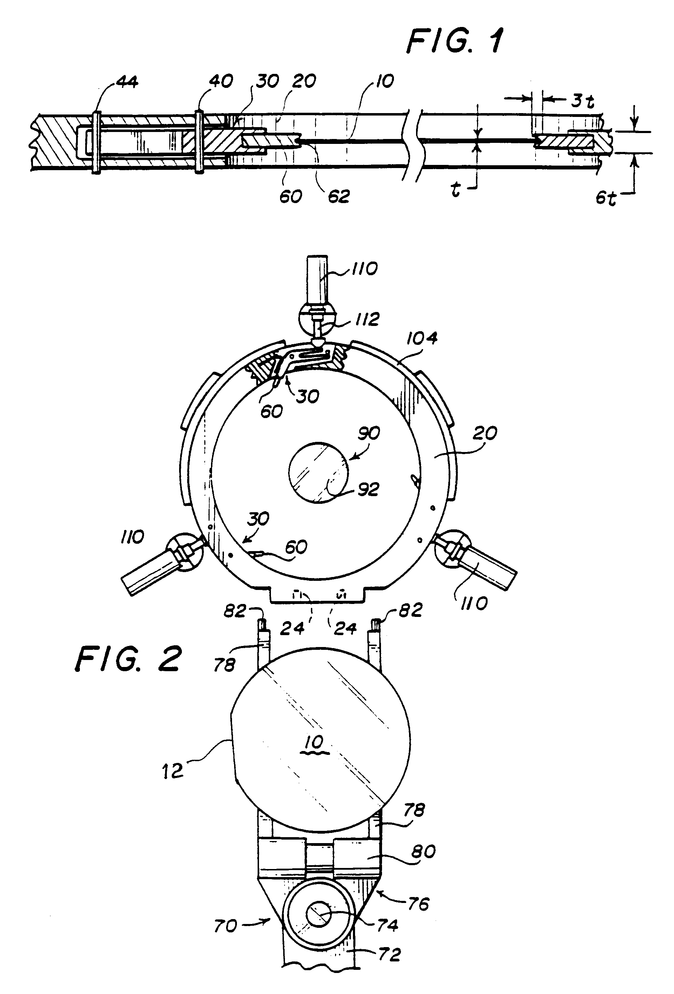

Referring now to Figure 1, a semiconductor wafer 10 is shown which has been inserted into a retaining ring 20, constructed of a metal such as aluminum, including anodized aluminum, or a ceramic material such as alumina, or any other material which will not interfere with processing of wafer 10.

Wafer 10 may be held within retaining ring 20 by engagement with tips 60 on the ends of yieldable clip mechanisms 30 while the wafer is moved between processing stations as well as being retained therein during a number of process steps without any direct handling of the wafer after initial insertion and prior to removal of the wafer after such processing steps.

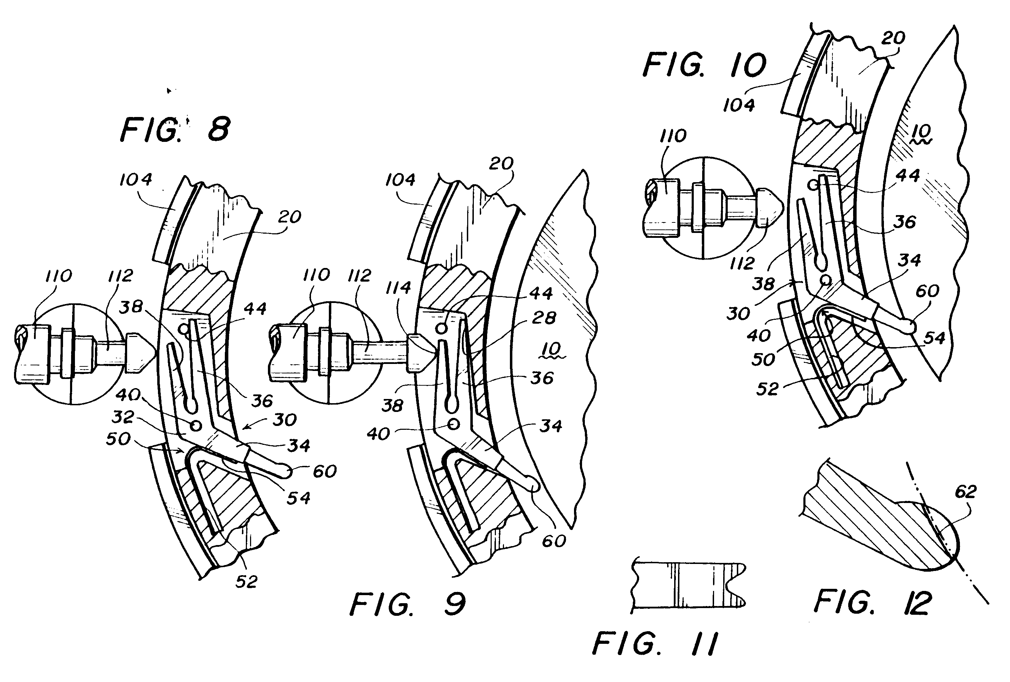

The height or thickness of tip 60 on clip mechanism 30 will be about 6t where t = the thickness of wafer 10, which usually ranges from about 0.71 to 0.81 mm , i.e., the height or thickness of ceramic tip 60 is dimensioned to not exceed about 6 times the thickness of wafer 10 to minimize interference with the processing of both sides of wafer 10. The depth of the grooved end surface 62 in which wafer rests when engaged by clip mechanism 30, as will be described in more detail below with respect to Figures 8-12, will be about 3t, i.e., about three times the thickness of wafer 10, again to minimize any interference with the processing of both sides of wafer 10.

As will be more clearly seen in subsequent figures, clip mechanisms 30, and tips 60 thereon, space the outer edge of wafer 10 from the inner diameter of retaining ring 20. Tip 60 extends from clip mechanism 30 a distance of at least about 12.2 mm or greater to prevent retaining ring 20 from interfering with the processing of wafer 10, i.e., which permits the wafer to remain mounted within the retaining ring during processing as well as during transport from one processing station to another, thus greatly reducing direct handling of the wafer in between processing steps.

Thus, even when the end of clip mechanism 30 is flush with the inner edge of retaining ring 20, retaining ring 20 is still separated from the outer edge of wafer 10 by a distance of at least 12.2mm-3t, where 3t is the depth of groove 62 in tip 60.

Therefore, the presence of retaining ring 20 around wafer 10 during processing of the wafer will not result in "shadowing" of the processing adjacent the periphery of wafer 10 in view of the spacing there between. In this regard, it will be further noted that the engagement of wafer 10 by clip mechanisms 30 and tips 60 is symmetrical with respect to the top and bottom surfaces of wafer 10, thus permitting equal access and processing of both top and bottom surfaces.

Furthermore, as can be seen in Figure 2 and subsequent top views, the lateral profiles of those portions of clip mechanisms 30 protruding from retaining ring 20, including tips 60, are very small, which also materially reduces interference with the various processing steps.

Referring now to Figure 2 and subsequent drawings, the loading of wafer 10 into retaining ring 20 will be explained. In Figure 2, a wafer 10 is shown being transported on a robotic means 70 in preparation for being loaded into a retaining ring 20.

Robotic means 70 includes a primary arm 72 and a secondary arm mechanism 76 pivotally connected to arm 72 by a shaft 74 into which secondary arm mechanism 76 has been pressed to permit rotation of secondary arm mechanism 76 by rotation of shaft 74 by external means such as a belt (not shown) around shaft 74. Secondary arm mechanism 76 is generally forked shaped having a pair of tines or fingers 78 thereon on which wafer 10 is transported and which respectively carry pins 82 on the ends thereof. Secondary arm mechanism 76 may further comprise fluid power means 80 for laterally moving fingers 78 apart or together which, together with pins 82, may be used in the engagement of retaining ring 20 by robotic means 70, as will be described below.

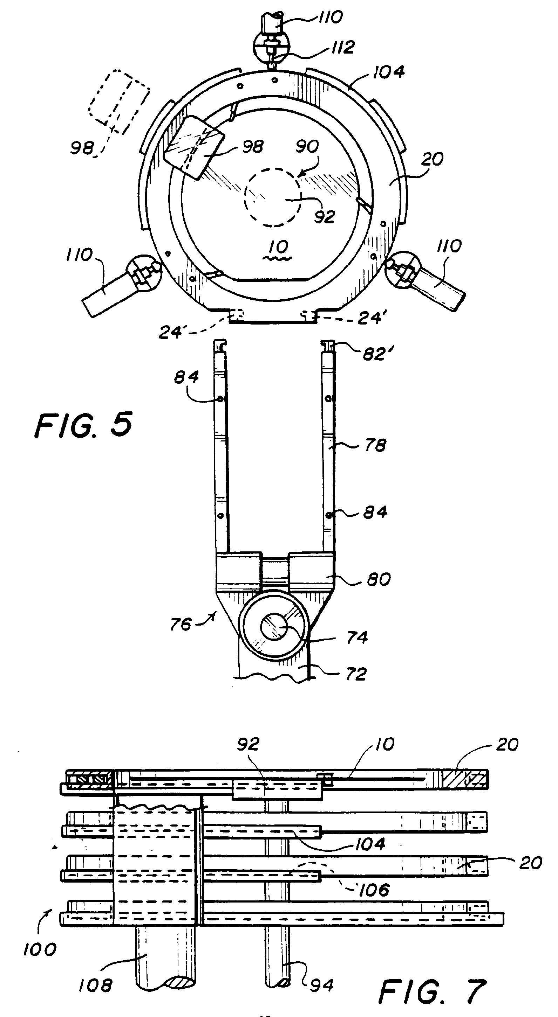

As seen more clearly in Figure 5, robot means 70 may be provided with friction pads 84, which may be formed from soft plastic materials, which are mounted on the upper surfaces of fingers 78 and which may be used to engage the underside of wafer 10 to prevent slippage without, however, damaging the surface of wafer 10.

Figure 2 also shows further construction details of one of the wafer engaging clip mechanisms 30 on retaining ring 20 which will be further described below in connection with Figures 8-10.

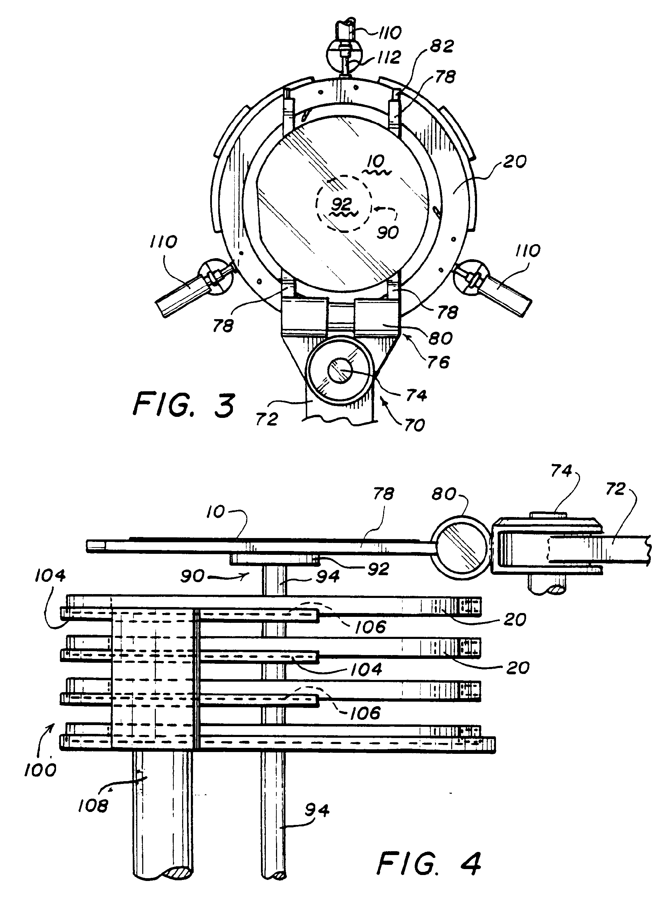

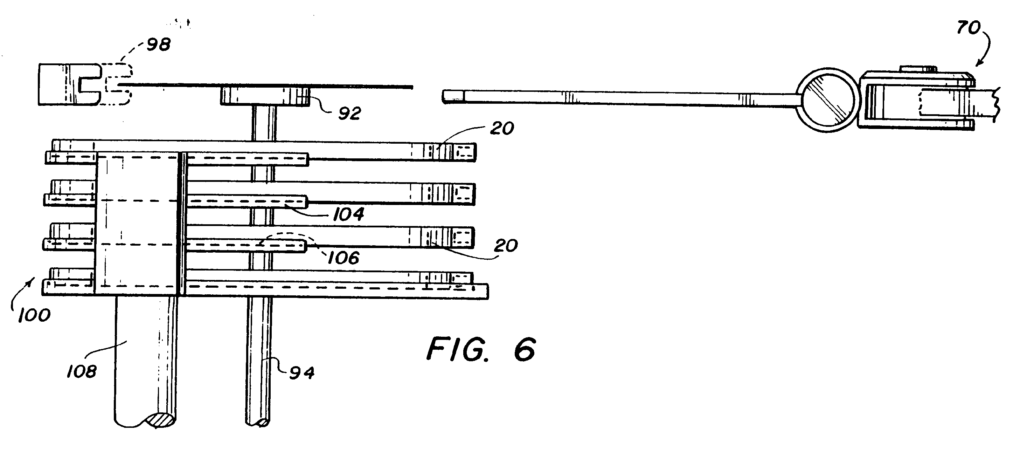

As shown in Figures 3 and 4, robot arm mechanism 70 moves wafer 10 into position over a rotatable orientation mechanism 90 comprising a platform or turntable 92 which may be raised and lowered, as well as rotated, by a shaft 94 beneath platform 92. When wafer 10 has been positioned by robot mechanism 70 over platform 92, shaft 94 is raised to remove wafer 10 from tines or fingers 78, as shown in Figures 5 and 6.

Still referring to Figure 4, raisable and rotatable orientation mechanism 90 is mounted within a storage mechanism 100 which is capable of holding a number of retaining rings 20 in a stacked relationship. As shown in the side views of Figures 4, 6, and 7, and in the top views of Figures 2, 3, and 5, a series of retaining rings 20 may be stacked in retainer ring storage mechanism 100 which may comprise a circular from 104 having a series of shoulders 106 thereon on which the respective retaining rings 20 may be stored. A support shaft 108 may be provided to raise and lower mechanism 100.

Orientation platform 92 is concentrically positioned within retaining ring storage mechanism 100 so that lowering of platform 92 will lower wafer 10 thereon into a position horizontally flush with the uppermost retaining ring in storage mechanism 100 to permit wafer 10 to be engaged by tips 60 on clips 30 on the uppermost retaining ring 20 within storage mechanism 100 as will be described below.

Referring now to Figures 5 and 6, after loading of wafer 10 onto orientation platform mechanism 90 and withdrawal of robotic mechanism 70, wafer 10 is rotated on platform 92 to orient the flat side 12 of wafer 10, with respect to retaining ring 20, for purposes of future processing as is well known to those skilled in the arm using suitable detection means such as the optical detector mechanism shown at 98 in Figure 5, or other suitable means such as an LED or CCD array with emitter.

Either before or after the rotational orientation of wafer 10 is completed, shaft 94 lowers platform 92 and wafer 10 thereon into a position for engagement of wafer 10 by clip mechanisms 30 on retaining ring 20 as shown in Figure 7.

As shown in top views of Figures 2, 3, and 5, a plurality of fluid power cylinders 110, which may be either pneumatic or hydraulic powered, are spaced around retaining ring storage mechanism 100 for engagement with clip mechanisms 30 via shafts 112, respectively coupled to each fluid power cylinder 110. Cylinders 110 are activated to laterally retract clip mechanisms 30, as will be described below, when a wafer 10 is lowered by platform mechanism 90 to the plane defined by the uppermost retaining ring 20 in retaining ring storage mechanism 100.

Referring now to the sequential steps shown in Figures 8-10 for engagement of wafer 10 by clip mechanisms 30, it will be seen that clip mechanisms are carried in cutaway portions of retaining ring 20 with only a small portion of the clip mechanism protruding from retaining ring for engagement with wafer 10. This serves to reduce any interference by the materials comprising clip mechanism 30 with the subsequent processing of wafer 10.

As shown in Figure 8, fluid power cylinder 110 is shown in an inactivated position with shaft 112 withdrawn from contact with clip mechanism 30.

Clip mechanism 30, in the embodiment shown in Figures 8-10, may comprise an aluminum or stainless steel crank member 32 pivotally mounted at pivot pin 40 to retaining ring 20. A spring 50, having a first portion 52 resting on the outer edge of retaining ring 20, has a second portion 54 which is yieldably urged against a first arm 34 of crank member 32 to maintain crank 32 normally in the position shown in Figure 8. A second arm 36 on crank 32 is urged by spring 50 against a second pin 44 which acts as a stop to limit the rotational travel of crank 32.

Fitted into an opening in the end of arm 34 is tip 60 which may be constructed of a metal such as aluminum, which may or may not be anodized, or a ceramic material such as alumina or to minimize any interference with the processing wafer 10 which is contacted by tip 60. As best seen in Figures 11 and 12, ceramic tip 60 is provided, at its end, with a concavely radiused or curved groove 62, i.e., a groove which, in side section may be v-shaped, as seen in Figure 11, and which, when viewed from the top, as seen in the cutaway top view of Figure 12, preferably closely matches the radius of the wafer edge, i.e., the curvature of the wafer when viewed from the top. This curvature of groove 62 will distribute the force exerted against the wafer by clip mechanism 30 when tip 60 is brought into contact with the end edge of wafer 10.

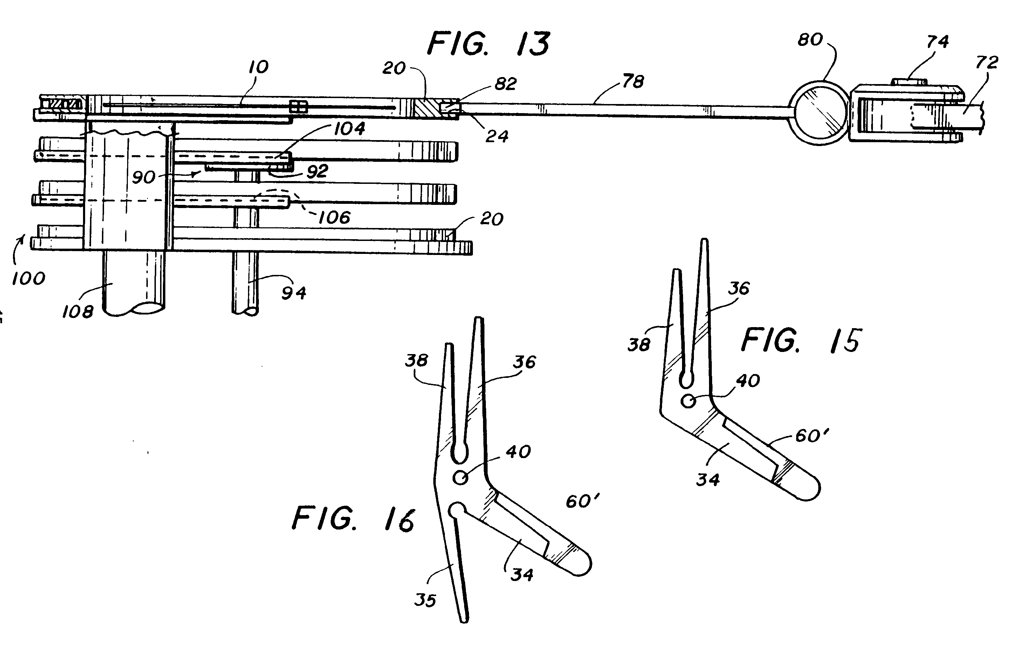

Figure 15 illustrates an alternates embodiment of clip mechanism 30 in which a ceramic tip 60′ is fitted to a cutaway portion of arm 34 and then suitably fastened to the side of arm 34 by bonding or the like.

In Figure 16, the embodiment shown in Figure 15 has been further modified. Spring 50 has been replaced by a yieldably arm 35 which is integral with crank 32 rather than a separate member.

Turning now to Figure 9, when wafer 10 has been lowered by platform mechanism 90 to a vertical position for loading wafer 10 into retaining ring 20 (Figure 7), fluid power cylinders 110 are activated to urge shafts 112 thereon into engagement at 114 with crank 32. The point of contact 114 of shaft 112 with crank 32 comprises a third arm 38 which is dimensioned in thickness to be thin enough to be slightly yieldable when shaft 112 bears against it for a purpose which will be explained below.

The movement of shaft 112 against arm 38 of crank 32 causes a clockwise rotation of crank 32 against the spring bias of spring 50 until arm 36 comes to a stop against retaining ring 20 at 28. This clockwise rotation of crank 32 causes arm 34 on each of the clip mechanisms mounted in retaining ring 20 to be withdrawn to a position which permits wafer 10 to be lowered to a horizontal plane which vertically bisects retaining ring 20 without interference from clip mechanisms 30.

Once wafer 10 reaches this position, fluid power cylinders 110 may be inactivated resulting in a withdrawal of shafts 112 from engagement with arms 38 on respective clip mechanisms 30. This permits spring 50 on each clip mechanism to urge crank 32 in a counterclockwise direction which moves arm 34 on crank 32 back toward the end edge of wafer 10 until tip 60 on arm 34 contacts wafer 10 as shown in Figure 10. At this point wafer 10 is yieldably secured in retaining ring 20 by clip mechanisms 30, and more particularly by the spring bias of springs 50.

When fluid power cylinders 110 are inactivated, the spring bias of spring 50 could cause arm 34 on crank 32 into a snapping engagement against wafer 10 which might result in damage to the wafer. However, the yieldable engagement of shaft 112 with arm 38 muffles or dampens the counterclockwise movement of crank 32 since the compression of arm 38 must first be removed before crank 32 will move.

Once clip mechanisms 30 on retaining ring 20 have been released to engage the end edges of wafer 10, as shown in Figures 10 and 13, robotic means 70 may be moved into position to engage retaining ring 20 by insertion of pins 82 (or 82′) on the ends of fingers or tines 78 of secondary arm mechanism 76 into sockets 24 or grooves 24′ on retaining ring 20, as shown, respectively, in Figures 2, 5, 14, and 17. At the same time support shaft 108 lowers retaining ring storage mechanism 100 to permit removal of the retaining ring 20 engaged by robotic mechanism 70.

When the openings in retaining ring 20 comprise grooves 24′, as shown in Figures 5, 14, and 17, robotic means 70 may be moved toward retaining ring 20 with fingers 78 in an extended position until contact is made with retaining ring 20 after which fingers 78 may be drawn toward one another by lateral movement means 80.

Alternatively, when the openings in retaining rings 20 comprise sockets 24, as shown in Figure 2, fingers 78 are moved toward one another or apart, as the case may be, until pins 82 on fingers 78 are aligned with sockets 24 in retaining ring 20 after which robotic means is laterally moved to insert pins 82 into socket openings 24.

To retain pins 82 or 82′ in either sockets 24 or grooves 24′ during subsequent movement of robotic means 70 to transport retaining ring 20 and wafer 10 mounted therein, lateral movement means 80 may then be energized to exert lateral pressure on the respective sidewalls of sockets 24 or grooves 24′ by pins 82 or 82′.

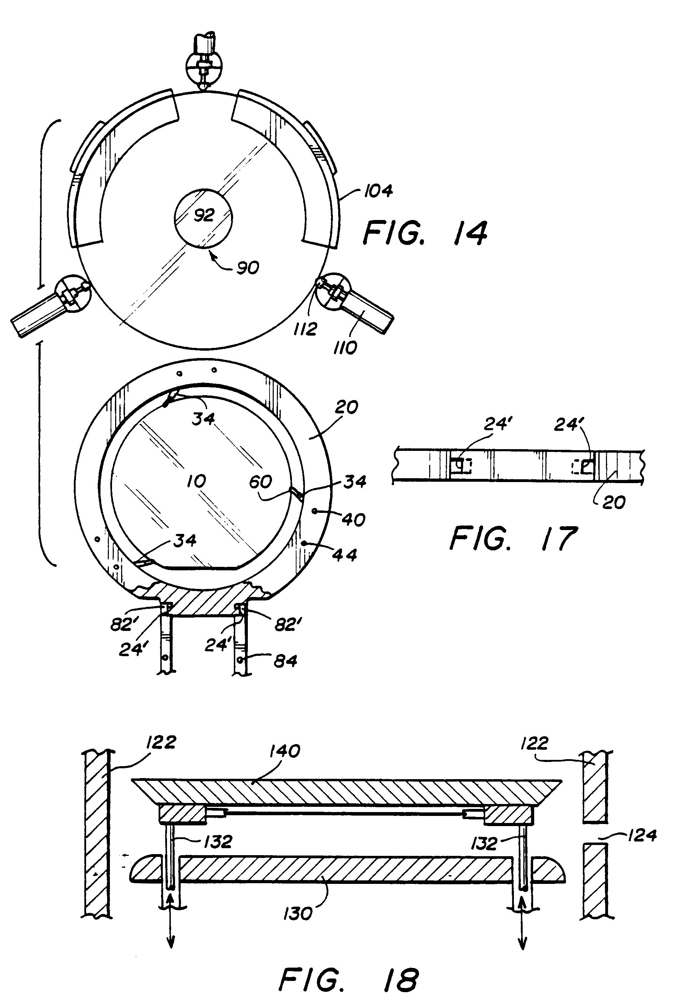

Robotic mechanism 70 may now transport the assembly comprising wafer 10 mounted in retaining ring 20 to a first process station generally indicated in Figure 18 by the broken away portions of walls 122 and opening 124. Robotic mechanism 70 may then deposit the wafer/retaining ring assembly on a cathode 130 in the first processing station and then robotic mechanism 70 is withdrawn from the processing station.

Either the top surface, bottom surface, or both surfaces of wafer 10 may now be suitably processed to construct integrated circuit structures therein. For example, as shown in Figure 18, the lift pins 132 in cathode 130 may be extended to clamp retaining ring 20 against anode 140 which is maintained at ground potential, thus effectively grounding wafer 10 while cathode 130 functions as the driven plane for processing of the backside of wafer 10. For this application, of course, it will be necessary that both ring 20 and tip 60 on clip mechanism 30 be constructed of metal or other electrically conductive materials to achieve the desired grounding of wafer 10.

When it is desired to remove the wafer/retaining ring assembly from the first processing station to move the assembly to a second station for further processing, lift pins 132 are withdrawn to lower wafer 10 back to the surface of cathode 130 and robotic mechanism 70 may then be used to reengage retaining ring 20 via sockets 24 therein and the wafer/retaining ring assembly is again transported to another processing station.

After all desired processing steps have been carried out, the wafer may be removed from the retaining ring by a reversal of the steps described above for insertion of the wafer into the retaining ring.

Thus, in accordance with the invention semiconductor wafer 10 may be transported to any number of processing stations where one or both sides of wafer 10 may be processed, i.e., etched, or have a layer of material deposited thereon or removed therefrom, etc. without any direct handling of the wafer and without interference from the retaining means used to engage the wafer, both in transport from one processing station to another as well as during actual processing in a particular processing station.

It should be further noted that the use of retaining ring 20 to engage wafer 10 need not be limited to operations such as depositions and dry etchings normally carried out in a single station or multiple station vacuum apparatus. Rather it is envisioned that wafer 10 may also be retained within retaining ring 20 during other process steps as well such as, for example, application, patterning, and removal of photolithography materials (photoresists), wet etching, etc. In the latter case, of course, care must be taken in selection of the type of material from which retaining ring 20 will be constructed to ensure that the retaining ring is not attacked by the etchant.

Basically, the features which a retaining ring constructed in accordance with the invention should include are: provision on the retaining ring for engagement of the ring by remote means to permit the retaining ring and wafer mounted therein to be transported from one processing station to another without direct handling of the wafer; a ring with an inner diameter sufficiently large to permit processing of both sides of the wafer equally without interference from the ring; and provision of a low profile releasable wafer engagement mechanism on the ring to permit the end edges of the wafer to be grasped by the retaining ring, with little if any interference with the processing of the wafer.

Thus, while the invention has been described with regard to specific embodiments of construction of the retaining ring of the invention, it will be understood that modifications of the retaining ring itself, including the means for grasping the wafer as well as the means used for engaging the retaining ring for remote transport may be made without departing from the invention.

## Claims

1. An apparatus for handling semiconductor wafers (10) including means supporting a semiconductor wafer (10) during production of integrated circuit structures, said means including a retaining ring (20) and holding means (30) for engaging said wafer (10) in the region of its periphery to retain it in a fixed position to said retaining ring (20), characterized in that
a) said retaining ring (20) has engagement means (24; 24′) thereon to permit said retaining ring (20) to be engaged for transfer of said retaining ring together with said wafer from one processing station to another to perform one or more processing steps on one or two surfaces of said wafer (10);
b) the inner diameter of said retaining ring (20) is sufficiently larger than the outer diameter of said wafer (10) to permit equal processing of both sides of said wafer without interference by said retaining ring; and
c) said means (30) laterally engage the end edges of said wafer (10) only leaving both the top and bottom surfaces of said wafer fully exposed for processing.

2. The apparatus of claim 1,
wherein said means (30) for engaging the end edges of said wafer (10) include clip means (30) carried by said retaining ring (20) and activatable to yieldably engage the end edges of said wafer (10) after insertion of said wafer (10) into said retaining ring (20).

3. The apparatus of claim 1 or 2,
wherein means (90, 92, 98) are further provided for radially orienting said wafer (10) preferably comprising a rotatable platform (92).

4. The apparatus of claim 3,
which further includes storage means (100) for removably storing a plurality of said retaining rings (20) in a vertical stack, including means (108) to lower said storage means (100) with respect to a wafer (10) once said wafer (10) has been loaded into said retaining ring (20) in said stack and wherein said rotatable platform (92) is concentrically mounted within said storage means (100) and is provided with means (94) for lowering said wafer (10) into a position for engagement with a retaining ring (20) stored in said vertical stack in said storage means (100).

5. The apparatus of claim 4,
wherein said apparatus further comprises robotic means (70) for engaging said engagement means (24; 24′) on said retaining ring (20) to permit said retaining ring (20) and said wafer therein to be moved without contacting said wafer (10) from one processing station to another said robotic means (70) engaging preferably a fixed point (24; 24′) on said ring (20) to which a flat side portion of said wafer (10) is radially oriented.

6. The apparatus of any preceding claim,
wherein said engaging means on said retaining ring are clip means (30) carried by said retaining ring (20) and activatable to yieldably engage the end edges of said wafer after insertion of said wafer (10) into said retaining ring (20) an inner diameter on said retaining ring (20) being sufficiently larger than the outer diameter of said wafer (10) to permit equal processing of both sides of said wafer (10) without shadowing by said retaining ring.

7. The apparatus of claim 6,
wherein said clip means (30) carried by said retaining ring (20) further comprise tip means (60) thereon constructed of a metal or a ceramic, said tip means (60) having a groove (62) therein to yieldably engage the end edges of said wafer (10), said groove (62) on said tip means preferably having a curvature therein substantially the same as the radius of said wafer (10) to distribute the force exerted by said clip means (30) against said wafer (10).

8. The apparatus of claim 6 or 7,
wherein both said retaining ring and said clip means (30) including said tip (60) thereon comprise electrically conductive materials to permit grounding said wafer (10) by contacting said retaining ring (20) to ground it.

9. The apparatus of any preceding claim,
wherein said engagement means comprises either sockets (24) or grooves (24′) formed in said retaining ring (20) to permit said retaining ring (20) to be engaged with a robot means (70) having gripping means complementary to said sockets (24) or grooves (24′).

## Patentansprüche

1. Eine Vorrichtung zum Handhaben von Halbleiterscheiben (10), die eine Einrichtung umfaßt, die eine Halbleiterscheibe (10) während der Erzeugung von integrierten Schaltungsstrukturen abstützt, wobei die Einrichtung einen Haltering (20) und Halteeinrichtungen (30) umfaßt, die mit der Halbleiterscheibe (10) im Bereich ihres Umfangs in Eingriff gebracht werden, so daß sie in einer festen Lage zum Haltering (20) gehalten wird, dadurch gekennzeichnet, daß
a) am Haltering (20) eine Eingriffseinrichtung (24; 24′) vorgesehen ist, so daß der Haltering (20) zum Transport des Halterings zusammen mit der Halbleiterscheibe von einer Bearbeitungsstation zu einer anderen zum Ausführen von einem oder mehreren Bearbeitungsschritten an einer oder an beiden Oberflächen der Halbleiterscheibe (10) in Eingriff bringbar ist;
b) der Innendurchmesser des Halterings (20) hinlänglich größer als der Außendurchmesser der Halbleiterscheibe (10) ist, so daß eine gleiche Bearbeitung beider Seiten der Halbleiterscheibe ohne Störung durch den Haltering möglich ist; und
c) die Halteeinrichtungen (30) nur seitlich an den Endkanten der Halbleiterscheibe (10) eingreifen, so daß sowohl die obere als auch die untere Fläche der Halbleiterscheibe für die Bearbeitung vollständig frei sind.

2. Die Vorrichtung nach Anspruch 1,
wobei die Halteeinrichtungen (30) zum in Eingriff bringen der Endkanten der Halbleiterscheibe (10) Klippeinrichtungen (30) umfassen, die vom Haltering (20) getragen werden und zum nachgebbaren in Eingriff bringen mit den Endkanten der Halbleiterscheibe (10) nach dem Einsetzen der Halbleiterscheibe (10) in den Haltering (20) aktivierbar sind.

3. Die Vorrichtung nach Anspruch 1 oder 2,
wobei ferner Einrichtungen (90, 92, 98) zum radialen Ausrichten der Halbleiterscheibe (10) vorgesehen sind, die vorzugsweise eine drehbare Plattform (92) aufweisen.

4. Die Vorrichtung nach Anspruch 3,
die ferner eine Lagereinrichtung (100) zum lösbaren Lagern einer Vielzahl von Halteringen (20) in einem vertikalen Stapel umfaßt, die eine Einrichtung (108) zum Absenken der Lagereinrichtung (100) bezüglich einer Halbleiterscheibe (10) einschließt, nachdem die Halbleiterscheibe (10) einmal in den Haltering (20) im Stapel eingebracht wurde, und wobei die drehbare Plattform (92) konzentrisch innerhalb der Lagereinrichtung (100) befestigt ist, und mit einer Einrichtung (94) ausgestattet ist, die die Halbleiterscheibe (10) in eine Lage zum in Eingriff bringen mit einem Haltering (20) absenkt, der im vertikalen Stapel der Lagereinrichtung (100) aufbewahrt ist.

5. Die Vorrichtung nach Anspruch 4,
wobei die Vorrichtung ferner eine Robotereinrichtung (70) zum in Eingriff bringen der Eingriffseinrichtung (24; 24′) mit dem Haltering (20) aufweist, so daß der Haltering (20) und die darin enthaltene Halbleiterscheibe von einer Bearbeitungsstation zu einer anderen bewegt werden kann, ohne die Halbleiterscheibe (10) zu berühren, wobei die Robotereinrichtung (70) vorzugsweise mit einer festgelegten Stelle (24; 24′) am Ring (20) in Eingriff bringbar ist, zu der ein flaches Seitenteil der Halbleiterscheibe (10) radial ausgerichtet ist.

6. Die Vorrichtung nach irgendeinem vorhergehenden Anspruch,
wobei die Eingriffseinrichtungen am Haltering Klippeinrichtungen (30) sind, die vom Haltering (20) getragen werden und zum nachgebbaren in Eingriff bringen mit den Endkanten der Halbleiterscheibe nach dem Einfügen der Halbleiterscheibe (10) in den Haltering (20) aktivierbar sind, wobei ein innerer Durchmesser des Halterings (20) hinlänglich größer als der Außendurchmesser der Halbleiterscheibe (10) ist, so daß eine gleiche Bearbeitung beider Seiten der Halbleiterscheibe (10) ohne Abschattung durch den Haltering möglich ist.

7. Die Vorrichtung nach Anspruch 6,
wobei an den Klippeinrichtungen (30), die vom Haltering (20) getragen werden, ferner Endstückeinrichtungen (60) vorgesehen sind, die aus einem Metall oder einer Keramik ausgebildet sind, wobei in den Endstückeinrichtungen (60) eine Rille (62) vorgesehen ist, die mit den Endkanten der Halbleiterscheibe (10) nachgebbar in Eingriff gebracht wird, wobei die in der Endstückeinrichtung vorgesehene Rille (62) vorzugsweise eine Krümmung aufweist, die im wesentlichen gleich dem Radius der Halbleiterscheibe (10) ist, so daß die durch die Halteeinrichtungen (30) gegen die Halbleiterscheibe (10) aufgebrachte Kraft verteilt wird.

8. Die Vorrichtung nach Anspruch 6 oder 7,
wobei sowohl der Haltering als auch die Klippeinrichtung (30) mit dem daran vorgesehenen Endstück (60) elektrisch leitfähige Materialien aufweisen, so daß eine Erdung der Halbleiterscheibe (10) ermöglicht wird, indem zum Haltering (20) zu dessen Erdung ein Kontakt hergestellt wird.

9. Die Vorrichtung nach irgendeinem vorhergehenden Anspruch,
wobei die Eingriffseinrichtung entweder Buchsen (24) oder Nuten (24′) aufweist, die in dem Haltering (20) ausgebildet sind, so daß der Haltering (20) mit einer Robotereinrichtung (70) in Eingriff bringbar ist, die zu den Buchsen (24) oder Nuten (24′) komplementäre Halteeinrichtungen aufweist.

## Revendications

1. Appareil pour traiter des plaquettes semi-conductrices (10), comprenant des moyens pour porter une plaquette semi-conductrice (10) pendant la production de structures de circuits intégrés, lesdits moyens comprenant une bague de retenue (20) et des moyens de maintien (30) pour venir en prise avec ladite plaquette (10) dans la région de sa périphérie afin de la maintenir dans une position fixe par rapport à ladite bague de retenue (20), caractérisé par le fait que :
a) ladite bague de retenue (20) comporte sur elle des moyens de venue en prise (24 ; 24′) pour permettre une venue en prise avec ladite bague de retenue (20) en vue du transfert de ladite bague de retenue, conjointement avec ladite plaquette, d'un poste de traitement à un autre afin de réaliser une ou plusieurs phases de traitement sur une surface de ladite plaquette (10) ou sur ses deux surfaces ;
b) le diamètre intérieur de ladite bague de retenue (20) est suffisamment plus important que le diamètre extérieur de ladite plaquette (10) pour permettre de traiter d'une manière égale les deux faces de ladite plaquette sans interférences de la part de ladite bague de retenue ; et :
c) lesdits moyens (30) viennent en prise latéralement avec les bords extrêmes de ladite plaquette (10), mais en laissant à la fois la surface supérieure de ladite plaquette et sa surface inférieure pleinement exposées au traitement.

2. Appareil selon la revendication 1, dans lequel lesdits moyens (30) pour venir en prise avec les bords extrêmes de ladite plaquette (10) comprennent des moyens de serrage (30) qui sont portés par ladite bague de retenue (20) et qui peuvent être activés en vue de venir en prise élastiquement avec les bords extrêmes de ladite plaquette (10) après l'insertion de ladite plaquette (10) dans ladite bague de retenue (20).

3. Appareil selon la revendication 1 ou 2, dans lequel des moyens (90, 92, 98) sont en outre prévus pour orienter radialement ladite plaquette (10), ces moyens comprenant de préférence une plate-forme tournante (92).

4. Appareil selon la revendication 3, qui comprend en outre des moyens de stockage (100) pour stocker de manière amovible une pluralité desdites bagues de retenue (20) dans une pile verticale, lesquels comprennent des moyens (108) pour abaisser lesdits moyens de stockage (100) par rapport à une plaquette (10), une fois que ladite plaquette (10) a été chargée dans ladite bague de retenue (20) contenue dans ladite pile, et dans lequel ladite plate-forme tournante (92) est montée d'une manière concentrique à l'intérieur desdits moyens de stockage (100), en étant pourvue de moyens (94) pour abaisser ladite plaquette (10) jusque dans une position où une bague de retenue (20) qui est stockée dans ladite pile verticale desdits moyens de stockage (100) vient en prise avec elle.

5. Appareil selon la revendication 4, dans lequel ledit appareil comprend en outre des moyens robotisés (70) pour venir en prise avec lesdits moyens de venue en prise (24 ; 24′) qui sont présents sur ladite bague de retenue (20), afin de permettre que ladite bague de retenue (20) et ladite plaquette qui est placée dans celle-ci soient déplacées d'un poste de traitement à un autre sans contact avec ladite plaquette (10), lesdits moyens robotisés (70) venant de préférence en prise avec un point fixe (24 ; 24′) qui est présent sur ladite bague (20) par rapport à laquelle une partie latérale plate de ladite plaquette (10) est orientée dans le sens radial.

6. Appareil selon l'une quelconque des revendications précédentes, dans lequel lesdits moyens de venue en prise qui sont présents sur ladite bague de retenue sont des moyens de serrage (30) qui sont portés par ladite bague de retenue (20) et qui peuvent être activés afin de venir en prise élastiquement avec les bords extrêmes de ladite plaquette après l'insertion de ladite plaquette (10) dans ladite bague de retenue (20), un diamètre intérieur de ladite bague de retenue (20) étant suffisamment plus important que le diamètre extérieur de ladite plaquette (10) pour permettre de traiter d'une manière égale les deux faces de ladite plaquette (10) sans que ladite bague de retenue ne porte une ombre.

7. Appareil selon la revendication 6, dans lequel lesdits moyens de serrage (30) qui sont portés par ladite bague de retenue (20) comprennent en outre sur eux des moyens d'extrémité (60) en métal ou en céramique, lesdits moyens d'extrémité (60) présentant intérieurement une rainure (62) destinée à venir en prise élastiquement avec les bords extrêmes de ladite plaquette (10), ladite rainure (62) ménagée dans lesdits moyens d'extrémité présentant de préférence une courbure qui est sensiblement la même que celle du contour de ladite plaquette (10), afin de distribuer la force qui est exercée par lesdits moyens de serrage (30) sur ladite plaquette (10).

8. Appareil selon la revendication 6 ou 7, dans lequel ladite bague de retenue et ledit moyen de serrage (30), y compris ladite extrémité (60) qui est montée sur lui, sont constitués tous les deux par des matières conductrices de l'électricité, afin de permettre la mise à la terre de ladite plaquette (10) par contact avec ladite bague de retenue (20) qui est à la terre.

9. Appareil selon l'une quelconque des revendications précédentes, dans lequel lesdits moyens de venue en prise comprennent des supports (24) ou des rainures (24′) qui sont formées dans ladite bague de retenue (20), afin de permettre que des moyens robotisés (70) viennent en prise avec ladite bague de retenue (20), ceux-ci présentant des moyens de préhension qui sont complémentaires desdits supports (24) ou desdites rainures (24′).
